# FASCICULE DE BREVET EUROPEEN

(11) **EP 3 370 256 B1**
(45) Date de publication et mention de la délivrance du brevet: **13.07.2022**
(21) Numéro de dépôt: 17186784.9
(22) Date de dépôt: 18.08.2017
(51) Int. Cl.: H01L 27/02, H01L 49/02, H02H 9/04

(54) **DISPOSITIF COMPACT DE PROTECTION D'UN CIRCUIT INTÉGRÉ CONTRE LES DÉCHARGES ÉLECTROSTATIQUES**
KOMPAKTE VORRICHTUNG ZUM SCHUTZ EINES INTEGRIERTEN SCHALTKREISES GEGEN ELEKTROSTATISCHE ENTLADUNGEN
STRUCTURE FOR PROTECTING AN INTEGRATED CIRCUIT AGAINST ELECTROSTATIC DISCHARGES

(30) Priorité: 03.03.2017 FR 1751731
(43) Date de publication de la demande: 05.09.2018
(73) Titulaire: STMICROELECTRONICS SA, 92120 Montrouge (FR)
(72) Inventeur: BOURGEAT, Johan, 38830 Saint Pierrre d'Allevard (FR)
(74) Mandataire: Casalonga

(56) Documents cités:
- WO-A1-2011/089179
- FR-A1- 2 747 246
- US-A1- 2003 223 166
- US-A1- 2004 257 728
- US-A1- 2010 148 267
- US-A1- 2011 006 342

## Description

Des modes de réalisation de l'invention concernent les dispositifs électroniques, et notamment ceux destinés à la protection des composants contre les décharges électrostatiques (ESD : ElectroStatic Discharge).

Dans le domaine de la microélectronique, une décharge électrostatique peut se produire tout au long de la vie d'un circuit intégré, et constituer un vrai problème pour la fiabilité des composants ou modules électroniques de ce circuit intégré, ainsi qu'une cause majeure de défaillance.

Une décharge électrostatique se traduit généralement par un pic de courant plus ou moins important et plus ou moins court entre deux bornes d'un module électronique du circuit intégré.

Pour qu'une décharge électrostatique ait lieu, il faut qu'une première borne du module reçoive la décharge, par exemple au contact d'un corps chargé électriquement, et qu'une deuxième borne fasse office de masse, par exemple en étant en contact avec un objet métallique.

Classiquement, une décharge électrostatique a lieu lorsque le circuit intégré est hors tension, entre deux bornes parmi la borne d'alimentation, la borne de référence, ou l'une des bornes de signal, couplée audit module.

Un dispositif de protection ESD vise à absorber autant que possible ce pic de courant afin d'éviter sa circulation dans le module, ou une surtension éventuelle aux bornes du module.

Il existe différentes protections contre les décharges électrostatiques, notamment les transistors MOS à fonctionnement hybride.

Les transistors à fonctionnement hybride sont des transistors MOS comportant un transistor bipolaire parasite et dont le fonctionnement fait intervenir un fonctionnement de ce transistor bipolaire et un fonctionnement du transistor MOS dans un mode sous-seuil.

Le principe d'un fonctionnement hybride d'un transistor MOS a été mis en évidence dans l'article de Ph. Galy et V. Berland intitulé « Ideal Gummel curves simulation of high current gain vertical NPN BIMOS transistor », INT. J. ELECTRONICS, 1996, vol. 80 N°6, 717-726. Cet article est une étude théorique effectuée sur un transistor à structure verticale présentant une longueur de grille (longueur de canal) de l'ordre du micron et validée par des simulations, sans qu'une quelconque application d'un tel fonctionnement hybride ne soit mentionnée.

Un tel transistor MOS à fonctionnement hybride a notamment l'avantage d'être résistant aux radiations ionisantes et il peut être d'une façon générale employé pour des applications grand public, spatiales ou militaires, dans les domaines numériques et analogiques.

L'utilisation d'un tel composant dans le cadre de la protection des circuits contre les décharges électrostatiques a notamment été décrite dans la demande de brevet internationale n° WO 2011 089179, ainsi que dans les documents FR2747 246-A1 et US2004/257728-A1.

Cela étant, certains dispositifs de protection ESD présentés dans cette demande internationale peuvent, dans certains cas, présenter certains inconvénients. Il a notamment été observé que lorsque le dispositif est couplé entre une borne de signal (borne d'entrée/sortie) et une borne d'alimentation du circuit intégré, et que l'environnement du circuit intégré n'est pas correctement maîtrisé, il est susceptible de se déclencher lors du fonctionnement du circuit intégré (donc en l'absence de décharge électrostatique), par exemple lorsque la différence de potentiel entre la borne d'alimentation et la borne de signal est supérieure ou égale au seuil de déclenchement du dispositif de protection.

Cela est susceptible d'endommager au moins une partie du circuit intégré et/ou de générer des erreurs de fonctionnement.

Il existe en outre un besoin de réduire autant que possible la surface occupée par le dispositif de protection, en particulier lorsque celui-ci est distribué sur les différentes bornes de signal couplées à différents composants ou modules électroniques du circuit intégré.

L'objet de l'invention est défini par la revendication 1. Certaines implémentations préférées sont définies par les revendication dépendantes.

Selon un mode de réalisation, il est proposé un dispositif électronique capable de protéger un composant ou un module électronique d'un circuit intégré contre les décharges électrostatiques survenant entre toute paire de bornes couplées audit composant ou module d'un circuit intégré, et ayant un encombrement réduit.

Selon un aspect, il est proposé un circuit intégré comportant
- une borne d'alimentation destinée à recevoir une tension d'alimentation,
- une borne de référence destinée à recevoir une tension de référence, par exemple la masse, et
- au moins une borne de signal destinée à recevoir/émettre un signal,
- un premier dispositif de protection couplé entre ladite au moins une borne de signal et la borne d'alimentation,
- au moins un deuxième dispositif de protection couplé entre ladite au moins une borne de signal et la borne de référence.

Selon cet aspect, le premier dispositif de protection comprend
- un premier transistor MOS dont une première électrode est couplée à ladite au moins une borne de signal,
- une deuxième électrode couplée à la borne d'alimentation,
- ledit au moins un deuxième dispositif de protection comporte un deuxième transistor MOS dont une première électrode est couplée à ladite au moins une borne de signal et une deuxième électrode est couplée à la borne de référence,
- les grilles des premier et deuxième transistors MOS étant couplées de manière directe ou indirecte à la borne de référence, et le substrat des premier et deuxième transistors étant couplé à la borne de référence par l'intermédiaire d'une résistance commune distincte desdits substrats.

Ainsi, un composant ou module électronique couplé à ces trois bornes est protégé contre les décharges électrostatiques se produisant entre la borne de signal et l'une ou l'autre des bornes de référence et d'alimentation, et la connexion du substrat et de la grille du premier transistor à une borne différente de la borne de signal permet avantageusement d'éviter, lorsque le circuit intégré est en fonctionnement, que la grille du premier transistor ne soit polarisée et que le premier transistor ne se déclenche, c'est-à-dire devienne passant.

Les grilles des premier et deuxième transistors peuvent être couplées de manière directe à la borne de référence, c'est-à-dire par une connexion ne faisant pas intervenir de composant intermédiaire actif ou passif, mais uniquement des éléments dont la seule fonction est de transmettre le signal, comme par exemple des pistes métalliques, des vias, etc.

En variante, les grilles des premier et deuxième transistors MOS peuvent être couplées à la borne de référence par l'intermédiaire d'un premier circuit de déclenchement, se traduisant donc par un couplage indirect.

Le premier circuit de déclenchement peut être de toute structure classique et comporter par exemple une autre résistance connectée entre les grilles des premier et deuxième transistors MOS et la borne de référence, sans connexion mutuelle entre la grille et le substrat de chaque transistor.

Cela étant, il est plus efficace que le premier circuit de déclenchement comporte ladite résistance commune.

Ainsi par ce couplage indirect, la grille et le substrat de chaque transistor MOS sont reliés et le transistor MOS est dans une configuration compatible avec un fonctionnement hybride du type de celui mentionné ci-dessus.

Selon un mode de réalisation, le circuit intégré comporte un troisième dispositif de protection couplé entre la borne d'alimentation et la borne de référence et comprenant un troisième transistor MOS dont une première électrode est couplée à la borne d'alimentation et une deuxième électrode est couplée à la borne de référence, et dont la grille est couplée de manière directe à la borne de référence et le substrat est couplé à la borne de référence par l'intermédiaire de la résistance commune.

Ainsi, le circuit intégré est protégé contre les décharges électrostatiques circulant entre la borne d'alimentation et la borne de référence.

Selon un autre mode de réalisation, le troisième transistor MOS dont une première électrode est couplée à la borne d'alimentation et une deuxième électrode est couplée à la borne de référence, a son substrat couplé à la borne de référence par l'intermédiaire de la résistance commune, et sa grille couplée à la borne de référence par l'intermédiaire d'un deuxième circuit de déclenchement.

Là encore pour des raisons d'efficacité, le deuxième circuit de déclenchement peut comporter la résistance commune.

Ainsi, là encore le troisième dispositif de protection est compatible avec les transistors à fonctionnement hybride, qui permettent d'améliorer le déclenchement des dispositifs de protection.

Selon un mode de réalisation, le circuit intégré comprend une première borne de signal et au moins une deuxième borne de signal, et au moins un quatrième dispositif de protection couplé entre la première borne de signal et la deuxième borne de signal et comprenant un quatrième transistor MOS dont une première électrode est couplée à la première borne de signal, une deuxième électrode est couplée à la deuxième borne de signal, dont la grille est directement couplée à la borne de référence, et dont le substrat est couplé à la borne de référence par l'intermédiaire de la résistance commune.

Selon un autre mode de réalisation, le quatrième transistor MOS de ce quatrième dispositif de protection a son substrat couplé à la borne de référence par l'intermédiaire de la résistance commune, et sa grille couplée à la borne de référence par l'intermédiaire d'un troisième circuit de déclenchement.

Le troisième circuit de déclenchement peut là encore comporter la résistance commune.

Les transistors peuvent être réalisés dans un seul et même substrat et avoir des grilles mutuellement connectées.

Cela permet notamment d'avoir un dispositif plus compact.

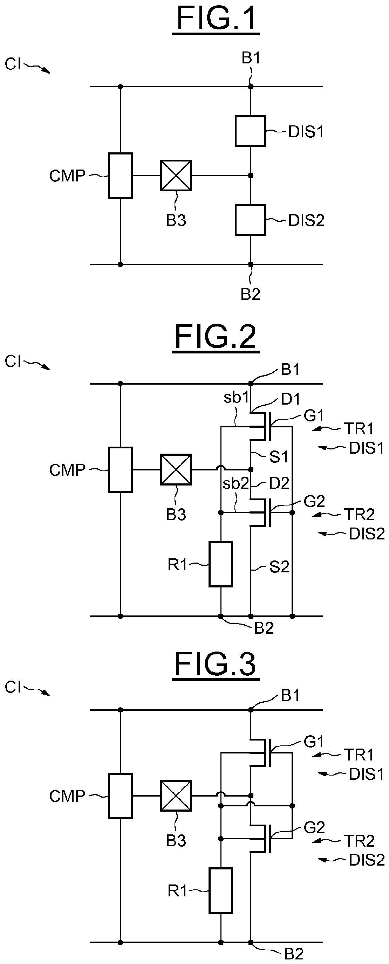

D'autres avantages et caractéristiques de l'invention apparaîtront à l'examen de la description détaillée de modes de réalisation de l'invention, nullement limitatifs, et des dessins annexés sur lesquels
- les figures 1 à 10 illustrent des modes de réalisation de l'invention.

Sur la figure 1, les références DIS1 et DIS2 désignent des dispositifs électroniques de protection d'au moins un composant ou d'un module électronique CMP d'un circuit électronique intégré CI contre les décharges électrostatiques (« Electrostatic Discharges » : ESD selon un acronyme anglo-saxon bien connu de l'homme du métier).

Le circuit électronique CI comporte une borne d'alimentation B1, une borne de référence B2 et une borne de signal B3, et le composant CMP est couplé à chacune de ces trois bornes B1, B2, et B3.

A titre indicatif, lorsque le circuit électronique est en fonctionnement, la borne d'alimentation B1 peut recevoir un signal d'alimentation, par exemple une tension positive, la borne B2 peut recevoir un signal de référence, par exemple une tension négative constante ou une tension nulle.

La borne de signal B3 peut recevoir ou émettre un signal de donnée depuis ou vers le module CMP.

Lorsque le circuit CI n'est pas en fonctionnement, le circuit CI peut être soumis à des décharges électrostatiques circulant entre l'une ou l'autre de ces bornes.

Une décharge électrostatique se traduit classiquement par une impulsion très brève de courant (par exemple quelques microsecondes) dont l'amplitude est par exemple de l'ordre de 2 ampères et intervient typiquement au bout de 10 nanosecondes.

Cela correspond par exemple à une différence de potentiel impulsionnelle appliquée entre deux bornes du circuit CI au travers d'un circuit équivalent R-L-C, dont le pic de tension se produit au bout de 10 nanosecondes avec une intensité de 1 à 4 kVolts HBM, par exemple 4 kVolts HBM pour 2,5 ampères.

On rappelle ici que les lettres HBM sont l'abréviation de l'acronyme anglo-saxon « Human Body Model » bien connu de l'homme du métier dans le domaine de la protection contre les décharges électrostatiques et désignent notamment un circuit électrique visant à modéliser une décharge électrostatique délivrée par un être humain et habituellement utilisé pour tester la sensibilité des dispositifs aux décharges électrostatiques. Ce circuit électrique HBM, qui est le circuit R-L-C équivalent mentionné ci-avant et auquel on applique une forte tension, comporte notamment un condensateur de 100 pF qui se décharge à travers une résistance de 1,5 kilo-ohms dans le dispositif à tester. Ainsi, dans le cas présent, une décharge électrostatique de 4 kilovolts HBM signifie que l'on applique au circuit électrique HBM une différence de potentiel de 4 kilovolts.

Il convient alors que cette impulsion de courant circule à travers l'un des dispositifs de protection DIS1 et DIS2 et non à travers le composant CMP.

Les dispositifs DIS1 et DIS2 visent par conséquent à absorber ces impulsions de courants survenant respectivement entre la borne d'alimentation B1 et la borne de signal, et entre la borne de référence et la borne de signal, ou entre les deux bornes B1 et B2.

Comme l'illustre la figure 2, les dispositifs DIS1 et DIS2 comprennent respectivement un premier transistor MOS TR1 et un deuxième transistor MOS TR2, montés en série entre la borne d'alimentation B1 et la borne de référence B2.

Le drain D1 du premier transistor TR1 est couplé à la borne d'alimentation B1, la source S1 du premier transistor TR1 est couplée à la borne de signal B3 et au drain D2 du deuxième transistor TR2, et la source S2 du deuxième transistor TR2 est couplée à la borne de référence B2.

La grille G1 du premier transistor TR1 et la grille G2 du deuxième transistor TR2 sont directement couplées à la borne de référence B2.

Une connexion ou un couplage direct s'entend ici comme étant une connexion ne faisant pas intervenir de composant intermédiaire actif ou passif, mais uniquement des éléments dont la seule fonction est de transmettre le signal, comme par exemple des pistes métalliques, des vias, etc.

Le premier transistor TR1 est ainsi dans une configuration communément désignée par l'homme du métier sous l'acronyme « GGNMOS » (Gate Grounded NMOS », en langue anglaise).

Le substrat sb1 du premier transistor TR1 et le substrat sb2 du deuxième transistor TR2 sont ici couplés à la borne de référence B2, par l'intermédiaire d'une résistance commune R1. Pour des tensions de seuil de transistors de l'ordre de 4 volts, la résistance commune R1 a dans ce mode de réalisation une valeur résistive de 500 ohms.

Cela étant, en fonction de l'application envisagée, il serait possible de choisir une autre valeur de résistance.

En pratique, le premier transistor TR1 et le deuxième transistor TR2 sont réalisés sur un seul et même substrat, comme il sera vu ci-après.

En présence d'une décharge électrostatique circulant depuis la borne d'alimentation B1 vers la borne de signal B3, la tension générée par la décharge électrostatique augmente jusqu'à atteindre la tension de claquage de la jonction drain-substrat du premier transistor TR1.

Le substrat sb1, qui correspond ici à la base du transistor bipolaire parasite du premier transistor MOS TR1, est donc polarisé et le transistor bipolaire parasite (et donc le premier transistor MOS TR1) devient passant.

A titre indicatif, le transistor TR1 se déclenche ici lorsque la tension à ses bornes atteint 4,5 volts.

Lorsque la décharge circule dans l'autre sens, c'est-à-dire depuis la borne de signal B3 vers la borne d'alimentation B1, la tension générée par la décharge électrostatique augmente jusqu'à atteindre la tension de claquage de la jonction drain-substrat du premier transistor TR1.

Le substrat sb1, qui correspond ici à la base du transistor bipolaire parasite du premier transistor MOS TR1, est donc polarisé et le transistor bipolaire parasite (et donc le premier transistor MOS TR1) devient passant.

Dans ce cas, le déclenchement du dispositif DIS1 est plus progressif, c'est-à-dire que pour une valeur de tension à ses bornes inférieure à 2,5 volts, l'intensité de courant au travers du dispositif DIS1 croît de manière linéaire, et au delà de 2,5 volts, l'intensité du courant traversant le premier dispositif DIS1 croît de manière exponentielle, tandis que la tension aux bornes du premier transistor TR1 se rapproche de façon asymptotique de 3,5 volts.

Lorsque la décharge circule depuis la borne de signal B3 vers la borne de référence B2, la tension générée par la décharge électrostatique augmente jusqu'à atteindre la tension de claquage de la jonction drain-substrat du deuxième transistor TR2.

Le substrat sb2, qui correspond ici à la base du transistor bipolaire parasite du deuxième transistor MOS TR2, est donc polarisé et le transistor bipolaire parasite (et donc le deuxième transistor MOS TR2) devient passant.

Le deuxième transistor TR2 présente une configuration de type GGNMOS, et la borne de référence B2 à laquelle sa grille G2 et son substrat sb2 sont connectés fait ici office de masse.

Le deuxième transistor TR2 se déclenche ici pour une tension à ses bornes égale à 4,2 volts.

Lorsque la décharge circule depuis la borne de référence B2 vers la borne de signal B3, l'impulsion est transmise par la résistance commune R1 sur le substrat sb2 du deuxième transistor TR2 et par la connexion directe sur la grille G2 du transistor MOS TR2.

Dans ce cas de figure, le deuxième transistor TR2 se déclenche de façon classique, dès que sa tension grille-source dépasse sa tension de seuil.

La polarisation du substrat sb2 permet d'abaisser la tension de seuil du deuxième transistor TR2. Ici, le transistor se déclenche pour une tension de 0,6 volt.

Dans le cas d'une impulsion de courant circulant depuis la borne d'alimentation B1 vers la borne de référence B2, la tension générée par la décharge électrostatique augmente jusqu'à atteindre la tension de claquage de la jonction drain-substrat du premier transistor TR1.

Le substrat sb1, qui correspond ici à la base du transistor bipolaire parasite du premier transistor MOS TR1, est donc polarisé et le transistor bipolaire parasite du premier transistor MOS TR1 devient passant.

Le substrat sb2 du deuxième transistor MOS TR2 est également polarisé en raison de la connexion entre les substrats sb1 et sb2, et le transistor bipolaire parasite du deuxième transistor MOS TR2 devient également passant.

Le premier transistor MOS TR1 et le deuxième transistor TR2 se déclenchent alors pour une tension entre les bornes B1 et B2 d'une valeur de 4,2 volts.

Dans le cas d'une décharge circulant entre la borne de référence B2 et la borne d'alimentation B1, la décharge est transmise simultanément sur la grille G1 du premier transistor TR1, sur la grille G2 du deuxième transistor TR2, sur le substrat sb1 du premier transistor TR1 et sur le substrat sb2 du deuxième transistor TR2.

Les deux transistors TR1 et TR2 se déclenchent donc de façon classique afin de faire circuler la décharge électrostatique.

Ainsi, le composant CMP est protégé contre les décharges électrostatiques pouvant survenir entre deux quelconques de ses trois bornes B1, B2 et B3.

Et, la connexion du substrat sb1 et de la grille G1 du premier transistor TR1 à une borne de référence B2, c'est-à-dire à une borne différente de la borne de signal B3, permet d'éviter, lorsque le dispositif est en fonctionnement et que par exemple la différence de potentiel entre la borne d'alimentation et la borne de signal est supérieure au seuil de déclenchement du transistor TR1, que la grille G1 du premier transistor TR1 ne soit polarisée et que le premier transistor TR1 ne se déclenche.

Selon un mode de réalisation illustré sur la figure 3, il serait possible que la grille G1 du premier transistor TR1 et la grille G2 du deuxième transistor TR2 soient couplées à la borne de référence par l'intermédiaire de la résistance commune R1.

Ainsi, chaque transistor a sa grille et son substrat mutuellement connectés.

Cela permet un fonctionnement hybride des transistors MOS TR1 et TR2.

En particulier, la résistance commune R1 et la capacité drain-grille du premier transistor MOS TR1 forme un premier résistif-capacitif de déclenchement permettant de transmettre l'impulsion électrostatique sur la grille du premier transistor MOS TR1. Ainsi, en présence d'une décharge électrostatique aux bornes du premier transistor MOS TR1, l'impulsion électrostatique sera transmise à la fois sur la grille G1 par l'intermédiaire des capacités drain-grille ou source-grille, et sur le substrat sb1 du premier transistor MOS TR1 par le claquage de la jonction drain-substrat ou source-substrat.

De même la résistance commune R1 et la capacité drain-grille du deuxième transistor MOS TR2 forment un premier résistif-capacitif de déclenchement permettant de transmettre l'impulsion électrostatique sur la grille du deuxième transistor MOS TR2. Ainsi, en présence d'une décharge électrostatique aux bornes du deuxième transistor MOS TR2, l'impulsion électrostatique sera transmise à la fois sur la grille G2 par l'intermédiaire des capacités drain-grille ou source-grille, et sur le substrat sb2 du deuxième transistor MOS TR2 par le claquage de la jonction drain-substrat ou source-substrat.

De plus, la présence de la connexion entre la grille et le substrat de chaque transistor permet à la grille de se polariser d'avantage et par conséquent d'amplifier les effets MOS et bipolaire conjugués, car plus la tension de grille se rapproche de la tension de seuil du transistor MOS, plus le gain en courant augmente.

Cela est particulièrement avantageux dans le cas d'une impulsion entre la borne d'alimentation B1 et la borne de signal B3 où le seuil de déclenchement est alors abaissé à 2,5 volts, et dans le cas d'une impulsion circulant depuis la borne de signal vers la borne de référence, où le seuil est abaissé à 1,5 volts par rapport au mode de réalisation décrit précédemment en lien avec la figure 2.

Dans ce mode de réalisation également, la connexion du substrat sb1 et de la grille G1 du premier transistor TR1, par l'intermédiaire de la résistance commune R1, à la borne de référence B2, c'est-à-dire à une borne différente de la borne de signal B3, permet d'éviter, lorsque le dispositif est en fonctionnement et que par exemple la différence de potentiel entre la borne d'alimentation et la borne de signal est supérieure au seuil de déclenchement du transistor TR1, que la grille G1 du premier transistor TR1 soit polarisée et que le premier transistor TR1 se déclenche.

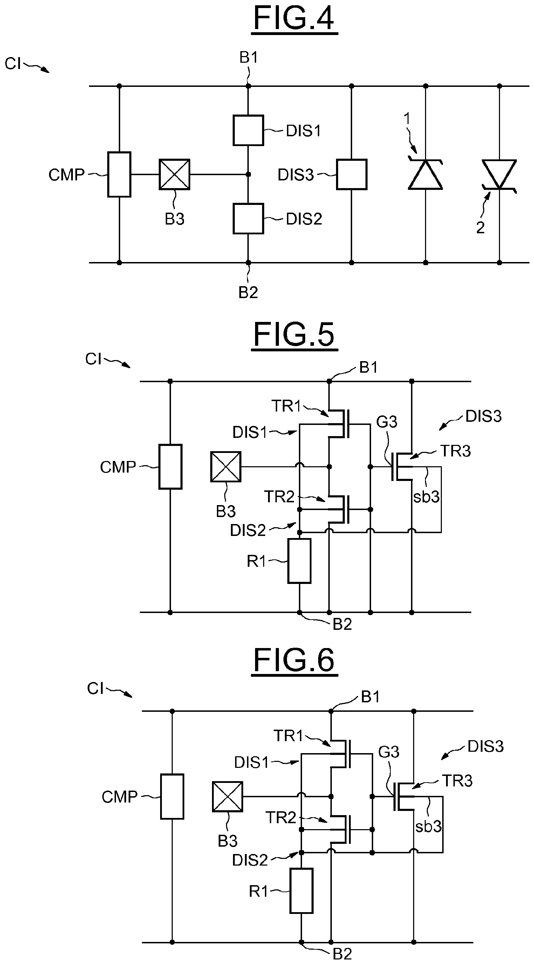

Selon un mode de réalisation illustré par les figures 4 à 6, il est également possible de coupler un troisième dispositif de protection DIS3 entre la borne d'alimentation B1 et la borne de référence B2.

Ce dispositif comporte un troisième transistor TR3, dont la grille G3 peut être connectée à la borne de référence de façon directe (figure 5) ou indirecte par l'intermédiaire de la résistance commune R1 (figure 6).

Ainsi, selon le mode de réalisation illustré sur la figure 5, en présence d'une décharge électrostatique circulant depuis la borne d'alimentation B1 vers la borne de référence B2, la tension générée par l'impulsion de courant augmente jusqu'à atteindre la tension de claquage de la jonction drain-substrat du troisième transistor MOS TR3.

Le substrat sb3, qui correspond ici à la base du transistor bipolaire parasite du troisième transistor MOS TR3, est donc polarisé et le transistor bipolaire parasite devient passant.

Le troisième transistor TR3 présente une configuration de type GGNMOS, et la borne de référence B2, à laquelle est connectée la grille G3 du troisième transistor MOS TR3, fait ici office de masse.

Ici, le transistor se déclenche pour une tension à ses bornes égale à 4,2 volts.

Et, le chemin de propagation de la décharge électrostatique est plus direct que si la décharge circulait depuis la borne d'alimentation B1 vers la borne de référence B2 par l'intermédiaire du premier transistor TR1 et du deuxième transistor MOS TR2, ce qui permet d'éviter la présence de surtensions due à la circulation de l'impulsion de courant au travers des deux transistors dont la valeur résistive n'est pas nulle.

En présence d'une décharge électrostatique circulant depuis la borne de référence B2 vers la borne d'alimentation B1, l'impulsion de courant est transmise par la résistance commune R1 sur le substrat sb3 du troisième transistor MOS TR3, et par la connexion directe sur la grille G3 du transistor MOS TR3.

Dans ce cas de figure, le troisième transistor TR3 se déclenche de façon classique, dès que sa tension grille-source dépasse sa tension de seuil.

La polarisation du substrat sb3 du troisième transistor MOS TR3 permet d'abaisser la tension de seuil du troisième transistor TR3. Ici, le troisième transistor MOS TR3 se déclenche pour une tension de 0,6 volt. Dans ce cas également, le chemin de propagation est plus direct que si l'impulsion circulait entre la borne de référence B2 et la borne de signal B1 via le premier transistor MOS TR1 et le deuxième transistor MOS TR2.

Selon le mode de réalisation illustré sur la figure 6, le seuil de déclenchement du troisième transistor MOS TR3 est abaissé à 1,5 volt dans le cas d'une décharge circulant de la borne d'alimentation B1 vers la borne de référence B2.

Dans le cas d'une décharge électrostatique circulant depuis la borne de référence B2 vers la borne d'alimentation B1, le courant traversant le transistor augmente de façon linéaire jusqu'à ce que la tension à ses bornes atteigne 1,5 volt, puis de façon exponentielle au delà de 2,5 volts, tandis que la tension à ces bornes s'approche de façon asymptotique de 3,5 volts.

Le circuit CI est ainsi protégé contre les décharges électrostatiques circulant entre la borne d'alimentation B1 et la borne de référence B2.

Quel que soit le mode de réalisation, les dispositifs de protection DIS1, DIS2 et DIS3 peuvent être réalisés en parallèle de dispositifs de protection existants, par exemple des diodes ou des thyristors.

Ainsi, sur la figure 4, deux thyristors 1 et 2 montés tête bêche sont couplés entre la borne d'alimentation B1 et la borne de référence B2.

La réalisation des dispositifs de protection DIS1, DIS2 et DIS3 est donc compatible avec les procédés de fabrication existants qui comportent la réalisation d'autre moyens de protection. Dans ce cas, les dispositifs existants peuvent soit fonctionner en parallèle des dispositifs DIS1, DIS2 et/ou DIS 3, soit être inhibés par les dispositifs DIS1, DIS2, et/ou DIS3.

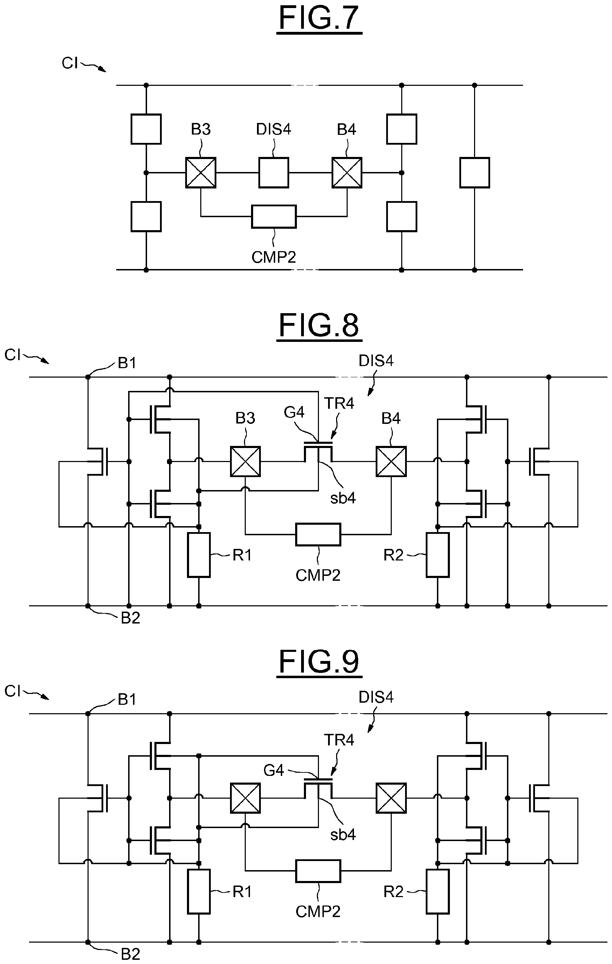

Il serait possible, comme l'illustre les figures 7 à 9, que le circuit intégré CI comprenne une pluralité de bornes de signal, dont une première borne de signal B3 et une deuxième borne de signal B4 seraient indirectement connectées par l'intermédiaire d'un module électronique CMP2.

En présence d'une décharge électrostatique entre la première borne de signal B3 et la deuxième borne de signal B4, il convient que cette impulsion de courant circule à travers un dispositif de protection et non à travers le module électronique CMP2.

Ainsi, le circuit intégré CI comporte un quatrième dispositif de protection DIS4 couplé entre la première borne de signal B3 et la deuxième borne de signal B4.

Comme l'illustre la figure 8, le quatrième dispositif de protection peut comporter un quatrième transistor MOS TR4, dont la grille G4 est directement couplée à la borne de référence B2, et dont le substrat sb4 est couplé à la borne de référence par l'intermédiaire de la résistance commune R1.

Il serait toutefois possible que le substrat sb4 du transistor intermédiaire TR4 soit couplé à la deuxième borne de signal B4 par l'intermédiaire de la résistance commune R2 aux circuits de protections associés à la deuxième borne de signal B4.

Le quatrième transistor TR4 a ici une configuration de type GGNMOS.

En présence d'une décharge électrostatique entre la première borne de signal B3 et la deuxième borne de signal B4, la tension générée par l'impulsion de courant augmente jusqu'à atteindre la tension de claquage de la jonction drain-substrat du quatrième transistor MOS TR4.

Le substrat sb4, qui correspond ici à la base du transistor bipolaire parasite du quatrième transistor MOS TR4, est donc polarisé et le transistor bipolaire parasite du quatrième transistor TR4 devient passant.

Selon une variante illustrée sur la figure 9, il serait possible que le transistor intermédiaire TR4 soit un transistor dans une configuration permettant un fonctionnement hybride, ayant sa grille G4 et son substrat sb4 mutuellement connectés de façon directe et couplés à la borne de référence B2 par l'intermédiaire de la résistance commune R1.

Cette configuration permet d'améliorer encore davantage le déclenchement du quatrième transistor TR4.

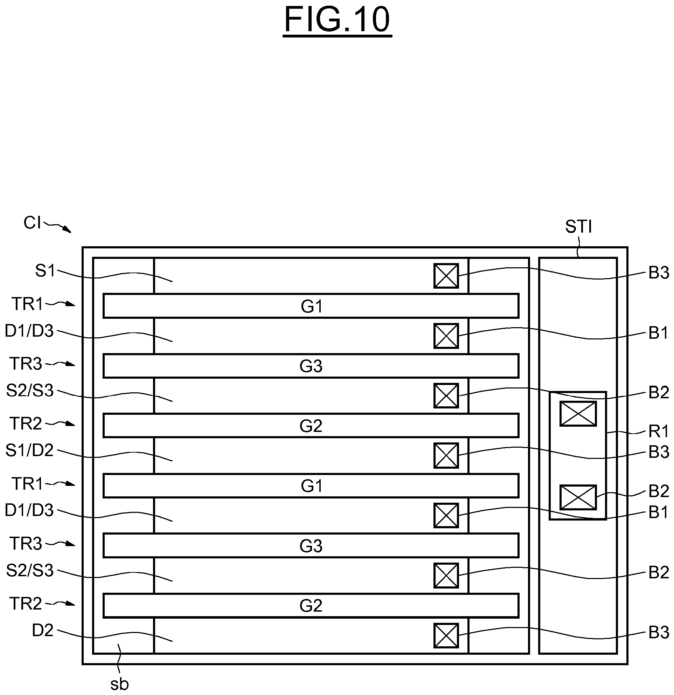

La figure 10 illustre une vue de dessus d'un circuit intégré CI comportant le premier transistor TR1, le deuxième transistor TR2, le troisième transistor TR3, et la résistance commune R1 selon le mode de réalisation décrit précédemment en lien avec la figure 5.

Les trois transistors sont réalisés sur un seul et même substrat sb, délimité par une tranchée d'isolation STI et sont réalisés de façon à partager au moins l'une de leurs électrodes.

Dans ce mode de réalisation, chaque transistor est réalisé en double, c'est-à-dire qu'il comporte en réalité deux transistors identiques montés en parallèle. Cela est équivalent à un transistor de taille plus importante, ce qui permet de supporter le passage de l'impulsion de courant résultant d'une décharge électrostatique.

Cela étant, chaque transistor pourrait comprendre un nombre quelconque de transistors identiques montés en parallèle, la taille du transistor équivalent étant d'autant plus grande que le nombre de transistors identiques est élevé.

Ainsi, le drain D1 du premier transistor TR1 et le drain D3 du troisième transistor TR3 sont confondus et connectés à la borne d'alimentation B1 par l'intermédiaire de vias et de pistes métalliques, la source S3 du troisième transistor TR3 et la source S2 du deuxième transistor TR2 sont confondues et connectées à la borne de référence B2 par l'intermédiaire de vias et de pistes métalliques, la source S1 du premier transistor TR1 et le drain D2 du deuxième transistor TR2 sont confondus et connectés à la borne de signal B3.

Les grilles G1, G2 et G3 sont mutuellement connectées et couplées à la deuxième borne B2 par l'intermédiaire de vias et de pistes métalliques. Cela étant, elles pourraient être connectées à la résistance commune R1 par l'intermédiaire de vias et de pistes métalliques.

Le substrat de chaque transistor est couplé à la résistance commune R1 par l'intermédiaire de vias et de pistes métalliques.

On obtient ainsi un système de protection ESD particulièrement compact.

Le substrat peut être un substrat massif ou un substrat de type silicium sur isolant (SOI : Silicon On Insulator).

## Revendications

1. Circuit intégré comportant une borne d'alimentation (B1) destinée à recevoir une tension d'alimentation, une borne de référence (B2) destinée à recevoir une tension de référence, et au moins une borne de signal (B3) destinée à recevoir/émettre un signal, un premier dispositif de protection (DIS1) couplé entre ladite au moins une borne de signal (B3) et la borne d'alimentation (B1), au moins un deuxième dispositif de protection (DIS2) couplé entre ladite au moins une borne de signal (B3) et la borne de référence (B2), le premier dispositif de protection (DIS1) comprenant un premier transistor MOS (TR1) dont une première électrode (S1) est couplée à ladite au moins une borne de signal (B3), une deuxième électrode (D1) est couplée à la borne d'alimentation (B1), ledit au moins un deuxième dispositif de protection (DIS2) comportant un deuxième transistor MOS (TR2) dont une première électrode (D2) est couplée à ladite au moins une borne de signal (B3) et une deuxième électrode (S2) est couplée à la borne de référence (B2), les grilles (G1, G2) des premier et deuxième transistors MOS (TR1, TR2) étant couplées de manière directe ou indirecte à la borne de référence (B2), et les substrats (sbl, sb2) des premier et deuxième transistors MOS (TR1, TR2) étant couplés à la borne de référence (B2) par l'intermédiaire d'une résistance commune (R1) **caractérisé en ce que** la résistance commune (R1) est distincte desdits substrats (sbl, sb2).

2. Circuit intégré selon la revendication 1, dans lequel les grilles (G1, G2) des premier et deuxième transistors MOS (TR1, TR2) sont couplées de manière directe à la borne de référence (B2).

3. Circuit intégré selon la revendication 1, dans lequel les grilles (G1, G2) des premier et deuxième transistors MOS (TR1, TR2) sont couplées à la borne de référence (B2) par l'intermédiaire d'un premier circuit de déclenchement (R1).

4. Circuit intégré selon la revendication 3, dans lequel le premier circuit de déclenchement comprend la résistance commune (R1).

5. Circuit intégré selon l'une quelconque des revendications 1 à 4, comportant un troisième dispositif de protection (DIS3) couplé entre la borne d'alimentation (B1) et la borne de référence (B2) et comprenant un troisième transistor MOS (TR3) dont une première électrode (D3) est couplée à la borne d'alimentation (B1) et une deuxième électrode (S3) est couplée à la borne de référence (B2), et dont la grille (G3) est couplée de manière directe à la borne de référence (B2) et le substrat (sb3) est couplé à la borne de référence par l'intermédiaire de la résistance commune (R1).

6. Circuit intégré selon l'une quelconque des revendications 1 à 4, comportant un troisième dispositif de protection (DIS3) couplé entre la borne d'alimentation (B1) et la borne de référence (B2) et comprenant un troisième transistor MOS (TR3) dont une première électrode (D3) est couplée à la borne d'alimentation (B1) et une deuxième électrode (S3) est couplée à la borne de référence (B2), dont le substrat (sb3) est couplé à la borne de référence (B2) par l'intermédiaire de la résistance commune (R1), et dont la grille (G3) est couplée à la borne de référence (B2) par l'intermédiaire d'un deuxième circuit de déclenchement.

7. Circuit intégré selon la revendication 6, dans lequel le deuxième circuit de déclenchement comprend la résistance commune (R1).

8. Circuit intégré selon l'une quelconque des revendications précédentes, comprenant une première borne de signal (B3) et au moins une deuxième borne de signal (B4), et au moins un quatrième dispositif de protection (DIS4) couplé entre la première borne de signal(B3) et la deuxième borne de signal (B4) et comprenant un quatrième transistor MOS (TR4) dont une première électrode est couplée à la première borne de signal (B3), une deuxième électrode est couplée à la deuxième borne de signal (B4), dont la grille (G4) est directement couplée à la borne de référence (B2), et dont le substrat (sb4) est couplé à la borne de référence (B2) par l'intermédiaire de la résistance commune (R1).

9. Circuit intégré selon l'une quelconque des revendications 1 à 7, comprenant une première borne de signal (B3) et au moins une deuxième borne de signal (B4), et au moins un quatrième dispositif de protection (DIS4) couplé entre la première borne de signal (B3) et la deuxième borne de signal (B4) et comprenant un quatrième transistor MOS (TR4) dont une première électrode est couplée à la première borne de signal, une deuxième électrode est couplée à la deuxième borne de signal, et dont le substrat (sb4) est couplé à la borne de référence (B2) par l'intermédiaire de la résistance commune (R1) et dont la grille (G4) est couplée à la borne de référence (B2) par l'intermédiaire d'un troisième circuit de déclenchement.

10. Circuit intégré selon la revendication 9, dans lequel le troisième circuit de déclenchement comporte la résistance commune (R1).

11. Circuit intégré selon l'une quelconque des revendications précédentes, dans lequel les transistors MOS (TR1, TR2, TR3, TR4) sont réalisés dans un seul et même substrat (sb) et ont des grilles mutuellement connectées.

## Patentansprüche

1. Integrierter Schaltkreis, eine Einspeiseklemme (B1) enthaltend, die dazu bestimmt ist, eine Einspeisespannung zu empfangen, eine Referenzklemme (B2), die dazu bestimmt ist, eine Referenzspannung zu empfangen und mindestens eine Signalklemme (B3), die dazu bestimmt ist, ein Signal zu empfangen/zu senden, eine erste Schutzvorrichtung (DIS1), die zwischen die mindestens eine Signalklemme (B3) und die Einspeiseklemme (B1) gekoppelt ist, und mindestens eine zweite Schutzvorrichtung (DIS2), die zwischen die mindestens eine Signalklemme (B3) und die Referenzklemme (B2) gekoppelt ist, wobei die erste Schutzvorrichtung (DIS1) einen ersten MOS-Transistor (TR1) umfasst, dessen erste Elektrode (S1) mit der mindestens einen Signalklemme (B3) gekoppelt ist und eine zweite Elektrode (D1) mit der Einspeiseklemme (B1) gekoppelt ist, wobei die mindestens eine zweite Schutzvorrichtung (DIS2) einen zweiten MOS-Transistor (TR2) enthält, dessen erste Elektrode (D2) mit der mindestens einen Signalklemme (B3) gekoppelt ist und eine zweite Elektrode (S2) mit der Referenzklemme (B2) gekoppelt ist, wobei die Gates (G1, G2) der ersten und zweiten MOS-Transistoren (TR1, TR2) direkt oder indirekt mit der Referenzklemme (B2) gekoppelt sind, und wobei die Substrate (sbl, sb2) des ersten und zweiten MOS-Transistors (TR1, TR2) über einen gemeinsamen Widerstand (R1) mit der Referenzklemme (B2) gekoppelt sind, **dadurch gekennzeichnet, dass** der gemeinsame Widerstand (R1) von den Substraten (sbl, sb2) getrennt ist.

2. Integrierter Schaltkreis nach Anspruch 1, wobei die Gates (G1, G2) des ersten und zweiten MOS-Transistors (TR1, TR2) direkt mit der Referenzklemme (B2) gekoppelt sind.

3. Integrierter Schaltkreis nach Anspruch 1, wobei die Gates (G1, G2) des ersten und zweiten MOS-Transistors (TR1, TR2) über eine erste Auslöseschaltung (R1) mit der Referenzklemme (B2) gekoppelt sind.

4. Integrierter Schaltkreis nach Anspruch 3, wobei die erste Auslöseschaltung den gemeinsamen Widerstand (R1) umfasst.

5. Integrierter Schaltkreis nach einem der Ansprüche 1 bis 4, eine dritte Schutzvorrichtung (DIS3) enthaltend, die zwischen die Einspeiseklemme (B1) und die Referenzklemme (B2) gekoppelt ist und einen dritten MOS-Transistor (TR3) umfassend, dessen erste Elektrode (D3) mit der Einspeiseklemme (B1) gekoppelt ist und eine zweite Elektrode (S3) mit der Referenzklemme (B2) gekoppelt ist, und dessen Gate (G3) direkt mit der Referenzklemme (B2) gekoppelt ist und das Substrat (sb3) über den gemeinsamen Widerstand (R1) mit der Referenzklemme gekoppelt ist.

6. Integrierter Schaltkreis nach einem der Ansprüche 1 bis 4, eine dritte Schutzvorrichtung (DIS3) enthaltend, die zwischen die Einspeiseklemme (B1) und die Referenzklemme (B2) gekoppelt ist, und einen dritten MOS-Transistor (TR3) umfassend, dessen erste Elektrode (D3) mit der Einspeiseklemme (B1) gekoppelt ist, und eine zweite Elektrode (S3) mit der Referenzklemme (B2) gekoppelt ist, dessen Substrat (sb3) über den gemeinsamen Widerstand (R1) mit der Referenzklemme (B2) gekoppelt ist, und dessen Gate (G3) über eine zweite Auslöseschaltung mit der Referenzklemme (B2) gekoppelt ist.

7. Integrierter Schaltkreis nach Anspruch 6, wobei die zweite Auslöseschaltung den gemeinsamen Widerstand (R1) umfasst.

8. Integrierter Schaltkreis nach einem der vorhergehenden Ansprüche, eine erste Signalklemme (B3) und mindestens eine zweite Signalklemme (B4) umfassend, und mindestens eine vierte Schutzvorrichtung (DIS4), die zwischen die erste Signalklemme (B3) und die zweite Signalklemme (B4) gekoppelt ist und einen vierten MOS-Transistor (TR4) umfassend, dessen erste Elektrode mit der ersten Signalklemme (B3) gekoppelt ist, eine zweite Elektrode mit der zweiten Signalklemme (B4) gekoppelt ist, dessen Gate (G4) direkt mit der Referenzklemme (B2) gekoppelt ist, und dessen Substrat (sb4) über den gemeinsamen Widerstand (R1) mit der Referenzklemme (B2) gekoppelt ist.

9. Integrierter Schaltkreis nach einem der Ansprüche 1 bis 7, eine erste Signalklemme (B3) und mindestens eine zweite Signalklemme (B4) umfassend, und mindestens eine vierte Schutzvorrichtung (DIS4), die zwischen die erste Signalklemme (B3) und die zweite Signalklemme (B4) gekoppelt ist und einen vierten MOS-Transistor (TR4) umfassend, dessen erste Elektrode mit der ersten Signalklemme gekoppelt ist und eine zweite Elektrode mit der zweiten Signalklemme gekoppelt ist, und dessen Substrat (sb4) über den gemeinsamen Widerstand (R1) mit der Referenzklemme (B2) gekoppelt ist und dessen Gate (G4) über eine dritte Auslöseschaltung mit der Referenzklemme (B2) gekoppelt ist.

10. Integrierter Schaltkreis nach Anspruch 9, wobei die dritte Auslöseschaltung den gemeinsamen Widerstand (R1) enthält.

11. Integrierter Schaltkreis nach einem der vorhergehenden Ansprüche, wobei die MOS-Transistoren (TR1, TR2, TR3, TR4) in einem einzigen Substrat (sb) ausgeführt sind und miteinander verbundene Gate aufweisen.

## Claims

1. An integrated circuit including a power supply terminal (B1) intended to receive a power supply voltage, a reference terminal (B2) intended to receive a reference voltage, and at least one signal terminal (B3) intended to receive/transmit a signal, a first protection device (DIS1) which is coupled between said at least one signal terminal (B3) and the power supply terminal (B1), at least one second protection device (DIS2) which is coupled between said at least one signal terminal (B3) and the reference terminal (B2), the first protection device (DIS1) comprising a first MOS transistor (TR1) including a first electrode (S1) coupled to said at least one signal terminal (B3), a second electrode (D1) coupled to the power supply terminal (B1), said at least one second protection device (DIS2) including a second MOS transistor (TR2) including a first electrode (D2) coupled to said at least one signal terminal (B3) and a second electrode (S2) coupled to the reference terminal (B2), the gates (G1, G2) of the first and second MOS transistors (TR1, TR2) being directly or indirectly coupled to the reference terminal (B2), and the substrates (sbl, sb2) of the first and second MOS transistors (TR1, TR2) being coupled to the reference terminal (B2) via a common resistor (R1) **characterised in that** the common resistor (R1) is distinct from said substrates (sbl, sb2).

2. The integrated circuit according to claim 1, wherein the gates (G1, G2) of the first and second MOS transistors (TR1, TR2) are directly coupled to the reference terminal (B2) .

3. The integrated circuit according to claim 1, wherein the gates (G1, G2) of the first and second MOS transistors (TR1, TR2) are coupled to the reference terminal (B2) via a first trigger circuit (R1).

4. The integrated circuit according to claim 3, wherein the first trigger circuit comprises the common resistor (R1).

5. The integrated circuit according to any one of claims 1 to 4, including a third protection device (DIS3) which is coupled between the power supply terminal (B1) and the reference terminal (B2) and comprising a third MOS transistor (TR3) including a first electrode (D3) coupled to the power supply terminal (B1) and a second electrode (S3) coupled to the reference terminal (B2), and whose gate (G3) is directly coupled to the reference terminal (B2) and substrate (sb3) is coupled to the reference terminal via the common resistor (R1).

6. The integrated circuit according to any one of claims 1 to 4, including a third protection device (DIS3) which is coupled between the power supply terminal (B1) and the reference terminal (B2) and comprising a third MOS transistor (TR3) including a first electrode (D3) coupled to power supply terminal (B1) and a second electrode (S3) coupled to the reference terminal (B2), whose substrate (sb3) is coupled to the reference terminal (B2) via the common resistor (R1), and whose gate (G3) is coupled to the reference terminal (B2) via a second trigger circuit.

7. The integrated circuit according to claim 6, wherein the second trigger circuit comprises the common resistor (R1).

8. The integrated circuit according to any one of the preceding claims, comprising a first signal terminal (B3) and at least one second signal terminal (B4), and at least one fourth protection device (DIS4) which is coupled between the first signal terminal (B3) and the second signal terminal (B4) and comprising a fourth MOS transistor (TR4) including a first electrode coupled to a first signal terminal (B3), a second electrode coupled to the second signal terminal (B4), whose gate (G4) is directly coupled to the reference terminal (B2), and whose substrate (sb4) is coupled to the reference terminal (B2) via the common resistor (R1).

9. The integrated circuit according to any one of claims 1 to 7, comprising a first signal terminal (B3) and at least one second signal terminal (B4), and at least one fourth protection device (DIS4) coupled between the first signal terminal (B3) and the second signal terminal (B4) and comprising a fourth MOS transistor (TR4) including a first electrode coupled to the first signal terminal, a second electrode coupled to the second signal terminal, and whose substrate (sb4) is coupled to the reference terminal (B2) via the common resistor (R1) and whose gate (G4) is coupled to the reference terminal (B2) via a third trigger circuit.

10. The integrated circuit according to claim 9, wherein the third trigger circuit includes the common resistor (R1).

11. The integrated circuit according to any one of the preceding claims, wherein the MOS transistors (TR1, TR2, TR3, TR4) are made in one and the same substrate (sb) and have gates which are mutually connected.
